# EUROPEAN PATENT SPECIFICATION

(11) **EP 3 900 063 B1**
(45) Date of publication and mention of the grant of the patent: **06.11.2024**
(21) Application number: 19829149.4
(22) Date of filing: 18.12.2019
(51) Int. Cl.: G06F 3/01, G06F 3/041, H10N 30/50, H10N 30/87, H10N 30/88, H10N 30/05

(54) **HAPTIC FEEDBACK WITH ELECTROACTIVE POLYMER TRANSDUCER DEVICE**
HAPTISCHE RÜCKMELDUNG MIT ELEKTROAKTIVER POLYMERWANDLERVORRICHTUNG
RÉTROACTION HAPTIQUE AVEC DISPOSITIF TRANSDUCTEUR À POLYMÈRE ÉLECTROACTIF

(30) Priority: 18.12.2018 DE 102018132598
(43) Date of publication of application: 27.10.2021
(73) Proprietor: Motherson Innovations Company Limited, London EC2N 2AX (GB)
(72) Inventor: LANGBEIN, Reinhold, 70327 Stuttgart (DE); RUDI, Artem, 70327 Stuttgart (DE); KRISCH, Wolfgang, Stuttgart 70327 (DE)
(74) Representative: Weber-Bruls, Dorothée
(86) International application number: PCT/EP2019/086090
(87) International publication number: WO 2020/127580

(56) References cited:
- EP-A2- 2 323 188
- WO-A1-2010/104953
- WO-A2-2012/122438
- WO-A2-2013/034549
- CH-A1- 706 837
- DE-A1- 102012 015 168
- REITELSHÖFER S ET AL: "Aerosol-Jet-Printing silicone layers and electrodes for stacked dielectric elastomer actuators in one processing device", ELECTROACTIVE POLYMER ACTUATORS AND DEVICES (EAPAD) 2016, 21-24 MARCH 2016, LAS VEGAS, NV, USA; PROCEEDINGS OF SPIE, vol. 9798, 97981Y, 2016, XP060070749, ISBN: 978-1-5106-1533-5, DOI: 10.1117/12.2219226
- KLUG F ET AL: "Fabrication of dielectric elastomer stack transducers (DEST) by liquid deposition modeling", ELECTROACTIVE POLYMER ACTUATORS AND DEVICES (EAPAD) 2017, 26-29 MARCH 2017, PORTLAND, OR, USA; PROCEEDINGS OF SPIE, vol. 10163, 101632Q, 2017, XP060090208, ISBN: 978-1-5106-1533-5, DOI: 10.1117/12.2256713
- YUN S ET AL: "Polymer-Based Flexible Visuo-Haptic Display", IEEE/ASME TRANSACTIONS ON MECHATRONICS, vol. 19, no. 4, August 2014 (2014-08-01), pages 1463 - 1469, XP011546573, ISSN: 1083-4435, DOI: 10.1109/TMECH.2013.2292956

## Description

The present invention relates to a method to operate an electroactive polymer transducer device.

Car interiors and cockpits have always been a favorite location for switches and all kinds of input/output (I/O) devices and human machine interfaces (HMI). In recent years, their design and placement have become important due to a number of reasons, in particular the following reasons:
(a) the number of functions and systems to control has increased,
(b) the demands for ergonomic switches have increased, meaning aiming for switches to be reached, understood and operated easily, and
(c) design requirements demand a good styling and at least partly invisible switch (hidden switch).

Traditionally the switches were electro-mechanical devices assembled separately in the interior and cockpit, directly switching the electric load. Recently they have become connected to a microcontroller (via lines or bus systems) and control electronic switch systems.

In order to deeper embed the input devices in the structure of the dashboard, there is a need to do this while manufacturing the structure or the surface of the dashboard and avoid a later assembly process of a separate switch. As a presumption, such devices have to be reliable compact devices being easily to produce.

As customers appreciate an appealing optic and a mechanical/haptic click of a switch device, a haptic feedback is an important principle of good HMI designs. Thus, there is a need to design such devices in a way they can give feedback to users operating the switches in addition to esthetic design requirements.

Among the various sub-classes of electroactive polymers (EAP), dielectric elastomers (DE) are used in products due to their simple operation principle, industrial scale manufacturability and long lifetime. Mechanical sensors, actuators and/or energy generators, even within a single device, each comprise an electrical insulating layer of elastomer, sandwiched between two deformable layers of electrically conductive material providing two electrodes.

A dielectric polymer actuator known from US 2005/0200238 A1 comprises a laminate-type actuating part, comprising: at least one dielectric polymer film which has first and second surfaces positioned opposite to each other and a side surface interposed between the first and second surfaces and which includes an incompressible dielectric polymer; and first and second compliant electrodes connected to the first and second surfaces, respectively; and a frame formed along the side surface of the dielectric polymer film so that pre strain applied to the dielectric polymer film is about zero, wherein, when a voltage is applied through the first and second compliant electrodes to the dielectric polymer film, the laminate-type actuating part is warped in any one direction of first and second surface directions to provide displacement corresponding to the voltage applied.

WO 2013/034549 A2 refers to an elastomer coating head with a coating nozzle, by means of which an elastomer layer for forming a dielectric layer of a dielectric elastomer stack actuator or sensor can be applied, wherein the coating nozzle is operatively connected to expansion means, so that a nozzle opening of the coating nozzle exiting material jet in a y-direction is expandable during a movement of the elastomer coating head in an x-direction.

CH 706 837 A1 teaches a method for producing a multilayer dielectric elastomer stack actuator, comprising a plurality of dielectric layers consisting of at least one solidified elastomer which is embedded between a plurality of electrode layers, with the following steps: i) applying a liquid uncrosslinked elastomer to form the dielectric layer with a reproducible layer thickness smaller than 50 µm by means of a grid device on a substrate, followed directly by ii) application of electrically conductive material particles to the surface of the dielectric layer made of liquid elastomer, to form an electrode layer utilizing the surface tension of the elastomer and a finale iii) at least partial crosslinking of the dielectric layer with the electrode layer floating on the surface by thermal treatment and / or irradiation, and repetition of the steps i) to iii), all steps taking place under clean room conditions and with the stationary substrate holder (1) and substrate held stationary.

EP 2 323 188 A2 describes an interconnection electrode structure comprising: a plurality of non-actuating layers comprising polymer layers, extension electrodes disposed at upper surfaces of the polymer layers, and a via hole (H1, H2) which penetrates through the plurality of non-actuating layers and comprises a diameter which increases in a stepwise manner upwards; and a common electrode formed in the via hole to connect the extension electrodes at the via hole to each other.

DE 10 2012 015 168 A1 teaches a multi-layer structural component for motor vehicles, which has at least one structural support and a cover film arranged thereon, wherein the cover film is a biopolymer film.

WO 2010/104953 A1 refers to a user interface device for manipulation by a user and having an improved haptic effect in response to an output signal, the device comprising: a base chassis adapted to engage a support surface; a housing coupled to the base and having a user interface surface configured to be manipulated by the user; at least one electroactive polymer actuator adjacent to the user interface surface, the electroactive polymer actuator configured to output a haptic feedback force associated with the output signal; where the housing is configured to enhance the haptic feedback force generated by the electroactive polymer actuator.

WO 2012/122438 A2 refers to an electronic damping feedback control system for an electroactive polymer module, the system comprising: an electronic damping controller coupled in a feedback loop between a user interface device and an electroactive polymer actuator, wherein the actuator is coupled to the user interface device, and wherein the electronic damping controller is configured to receive an actuation signal from the user interface device in response to a user input and, in response to the actuation signal, the electronic damping controller is to generate an electronic damping signal to drive the actuator and dampen mechanical movement.

The latter two documents also disclose methods according to the preamble of independent claim 1.

It is an object of the present invention to provide a method to operate an electroactive polymer transducer device overcoming the drawbacks of the prior art. The electroactive polymer transducer device is in particular a compact and reliable input/output device, which is easy to produce.

This object is solved by a method to operate an electroactive polymer transducer device as combined actuator and sensing device with good haptic feedback in a click operation as a switch according to independent claim 1, comprising the steps of applying a counter-voltage to electrically conductive layers, having at least one plastic material layer comprising dielectric electroactive polymer material arranged therebetween, by a control unit, in order to hamper a thickness-reduction of an thr active area of the plastic material layer(s) when beginning to apply an external mechanical force to the electroactive polymer transducer device, preferably in at least one actuation area, until a common click-point is reached, and reversing the applied voltage by the control unit after the common click-point is passed to support the click operation.

A counter-voltage denotes voltage applied to the first and second electrodes with a polarity suitable to prevent an electrostrictive effect. Therefore, the external pressure has to overcome a certain threshold to result in a decreased thickness of the stack of layers resulting in a change of voltage to be sensed. The felt mechanical resistance against the applied pressure is high in the beginning and decreases after the click-point, which provides an excellent haptic feedback to the user. The mechanical/haptic click of the resulting switch device is appreciated by customers and haptic feedback is an important principle of good HMI designs provided by the method of operation according to the present invention. This effect is difficult to achieve by the material properties of the plastic layers alone.

According to embodiments, dielectric elastomers are used as sensors. Said sensors can be provided in form a sensor film which can be integrated on or below a surface of a vehicle component. Such a sensor film can comprise a multi sensor area in order to be used for different control approaches. A localized feedback arrangement can be provided by which a person can recognize the boundary of a virtual button and can also guide the finger blindly from one location to another on a surface without the need of a specific shape of said surface. The electroactive polymer transducer device can comprise at least one stack of multiple layers deposited on a base film, plate or wall and/or within a housing with at least one housing wall, preferably extending from the base wall, where the stack comprises an alternating sequence of plastic material layers and electrically conductive layers on top of each other, with at least one plastic material layer, being sandwiched between two electrically conductive layers, wherein each plastic material layer comprises at least one active area made of an elastic polymer providing an electrostrictive effect, with the active area being arranged laterally adjacent to at least one fixation area or at least one housing wall made of solid plastic material in direct contact to the active area, and/or the active area extending across the complete plastic material layer, wherein the electrically conductive layers are arranged in an alternating sequence of first and second electrodes to apply a voltage between first and second electrodes to the respective active area(s) in order to induce or sense the electrostrictive effect of the elastic polymer of the plastic material layer arranged therebetween, and wherein the stack of layers is prepared by three-dimensional printing technology.

In one alternative, with the multiple layers being deposited on a base plate, the first electrode at least partly covers a first fixation area of the fixation area and the active area of the adjacent plastic material layers and the second electrode at least partly covers a second fixation area of the fixation area and the active area of the adjacent plastic material layers. In another alternative, with the multiple layers being deposited within a cavity defined by at least one housing wall, preferably at least one housing wall and a base wall of the housing, all layers are in contact with the at least one wall.

The elastic polymer might be any suitable polymer material showing the electrostrictive effect. Electrostriction is a property of electrical non-conductors, or dielectrics, which causes them to change their shape under the application of an electric field, and is caused by a slight displacement of ions in the crystal lattice upon being exposed to an external electric field. Positive ions will be displaced in the direction of the field, while negative ions will be displaced in the opposite direction. This displacement will accumulate throughout the bulk material and result in an overall strain (elongation) in the direction of the field. The thickness will be reduced in the orthogonal direction of a layer of such material characterized by Poisson's ratio. The area of the layer, where the electrostrictive effect occurs, is denoted as active area. The elastic polymer might be a dielectric elastic polymer, preferably a material with a high dielectric coefficient. The plastic material for the fixation areas might be any plastic material with significant lower elasticity as the material of the active area. In the active area, the material may have a hardness of 10 shore-A or more. In the fixation area the material may have a hardness of at least 60 shore-A, preferably of 20 - 90 shore-D. The hardness according to the shore scale measures the resistance of a sample to material deformation due to a constant compression load from a sharp object. The material for the electrically conductive layers might be any material providing a sufficient conductivity to apply a homogeneous voltage across the active area underneath or on top of the electrically conductive layer, e.g. a conductive ink applied during layer preparation.

Active and fixation areas of the plastic material layers of some embodiments are arranged laterally adjacent meaning that the corresponding areas of one layer are located beside each other in a direction parallel to the layer surface. In contrast to that, the electrode layers are arranged underneath and/or on top of each of the plastic material layer. The first and second fixation areas might be arranged on the same side of the device or might be arranged on the left and on the right of the active area, when considering a side view of the layer stack. On the same side denotes an arrangement, where the fixation areas are located either on the right or on the left side of the stack of layers. The first and second fixation areas may also embrace the active area in a circle fully or partly. In case of arranging the fixation areas on the same side of the active area, the resulting device can be manufactured with smaller lateral sizes enabling a placement of more corresponding devices in a given area.

In other embodiments the active area(s) can be embraced by one or more housing side walls. Three-dimensional (3D) printing technology is an excellent solution for depositing many stable layers with good stacking accuracy. 3D Printing is based on a similar number of layers as required for manufacturing the electroactive polymer transducer device according to the present invention. 3D-printing is a technology suitable to provide a layer stack being flexible, e.g. in the middle where the active area(s) is/are arranged, which change its thicknesses due to applied voltage or applied external mechanical force, and being stable at the fixation areas to reliably apply an electrical contact to the electrodes. Alternative technologies such as ablation, milling, sputtering, evaporation, Rakel-printing or centrifugal layer deposition are not suitable to produce as huge amount of electroactive polymer transducer device as required in mass production. The non-suited technologies require a huge amount of time and effort for producing an electroactive polymer transducer device leading to non-acceptable production costs. 3D-Printing is very suited for mass production of the electroactive polymer transducer device according to the present invention. With these technologies it is possible embed the electroactive polymer transducer device as input/output devices in the structure of the dashboard while manufacturing the structure or the surface of the dashboard avoiding a later assembly process of a separate electroactive polymer transducer device.

The resulting electroactive polymer transducer devices can be used as actuator devices and/or sensing devices such as switches. There is an opportunity to combine two devices according to the present invention in one arrangement and operate one of them as sensor or switch and the other one as an actuator and/or acoustic feedback device. In case of a combined sensor/actuator combination, the feedback mechanism can be programmed to mimic key-click characteristics of a mechanical switch over a wide range. Such specified characteristics, where for instance the resistance is high in the beginning and decreased after the click-point in common in the industry and is considered an excellent haptic feedback.

Therefore, the electroactive polymer transducer device provides a compact and reliable input/output device being easily to produce and being appreciated as human machine interface by the users.

In another embodiment the stack of layers comprises 10 to 50 sequences of plastic material layer and electrically conductive layer. The electrostrictive effect increases proportional to the number of layers comprising active material. The number of 10 - 50 layers provides an overall electrostrictive effect, which can be used to significantly actuate a component and to sense a pressure applied to the stack of layers with improved accuracy.

In an embodiment, the first electrodes are connected in parallel to be connected to a first polarity of a power supply, while the second electrodes are connected in parallel to be connected to a second polarity of the power supply. The parallel connection of all first and all second electrodes enables to use one simple power supply to supply voltage to all electrodes, where the polarity alternates in a vertical direction through the layer stack in order to achieve a maximum electrostrictive effect.

In another embodiment the first electrodes comprise first contacting areas at least partly covering the first fixation areas and the second electrodes comprise second contacting areas at least partly covering the second fixation areas, where, when projected onto the base plate, the first contacting areas at least do not fully cover the second contacting areas and vice versa. The first and second contacting areas can be used to connect the first and second electrodes to one or more power supplies. The at least partly non-overlapping first and second contacting areas and the resulting vertical coverage of the contacting areas for all first electrodes and separately also for all second electrodes enables to connect all first or all second electrodes together by just providing a vertical conductive path through all the corresponding first or second fixation areas of the layer stack.

In another embodiment the parallel connection of the first electrodes and also of the second electrodes is established by at least two separate conductive pins or vias extending through the stack of layers, of which at least one extending through the first contacting areas and not the second contacting areas and of which at least one extending through the second contacting areas and not the first contacting areas. This electrical connection can simply be established by inserting a pin vertical to the surface of the stack of layers into the already prepared layer stack just penetrating all layers to connect all first or second electrodes without the need of layer structuring during layer preparation. The resulting step for electrically connecting the electrodes is very simple and non-expensive. For example the pin or via may protrude from the layer stack and be connected to the power supply via conducting wires bonded to the protruding pin or via.

In another embodiment, the fixation area comprises separate first and second fixation areas, where the active area of each plastic material layer is arranged laterally between first and second fixation areas in direct contact to the active area. This arrangement provides a resulting electroactive polymer transducer device being mechanically more stable compared to a device where the fixation areas are arranged only on one side of the layer stack, because the active layer is supported by solid plastic material on both sides, or even laterally on all sides.

In another embodiment, the electrically conductive layers have smooth shape in lateral direction without edges at least in the area covering the active areas of the plastic material layers. The shape in lateral direction of a layer is the shape visible when looking on top of the layer in a vertical direction to the layer surface. This smooth lateral shape of the conductive layers avoids sharp edges eventually leading to non-desired peaks in voltage or current between adjacent electrodes and therefore prevent or suppress electrical discharges within the stack of layers. This protects the functionality of the electroactive polymer transducer device and increases its lifetime. In a preferred embodiment, the electrically conductive layers are circular shaped layers when seen in a vertical direction to a surface of the conductive layers. As an example, the shape of the electrically conductive layers may consist of a circle covering the active area completed by two tangential lines touching each of the electrodes in just one point covering the first and second fixation areas, where the electrodes might be connected by a conductive pin.

In another embodiment, the size of the active area decreases from layer to layer starting with the biggest size for the plastic material layer on top of the base plate. This further increases the resistance against electric discharges because the distance between the electrode edges of one electrode and the next electrode underneath is increased. Additionally the stack of layers becomes more elastic and stable. Here the active areas might be arranged symmetrically to the active area underneath, where a center of the active areas coincidence for all active areas. The active areas may also have a circular shape and might be arranged in a concentric way seen in a vertical direction to a surface of the active areas.

In another embodiment, the base plate is made of the solid plastic material also used to prepare the fixation areas. Using the same material as used for the fixation areas in the plastic material layers makes the production process more easily enabling to continue the layer deposition process without an interruption after having prepared the base plate. In another embodiment, 1 to 5 separate layers applied on top of each other establish the base plate. In case of using 3D printing the thickness of the base layer might be provided by printing 1 - 5 layers of the same material.

In an alternative embodiment, the base film comprises a stretchable and/or deformable layer, in particular in form of a textile film.

In another embodiment, in the plastic material layer the first and second fixation areas laterally fully embrace the active area. Here the first and second fixation areas give mechanical stability from all sides to the stack of layers, especially to the active area when changing its thickness due to application of voltage or external mechanical forces.

It is also possible that the complete plastic material layer provides an active area.

In other embodiments, the layer stack comprises a protective layer on at least one of its two opposite sides, and/or the layer stack is covered by a solid top cover or a slush skin and/or a décor layer on a side opposite to the base film, plate or wall. The cover can adapt the haptic feeling of the electroactive polymer transducer device by being touch by a user is case of applying the electroactive polymer transducer device as a sensor device. In addition, the cover can be provided with decor features.

The protective layer can be in form of a paint; the slush skin can comprise polyurethane; and the décor layer can be provided as a leather layer. But it is also possible that two or all layers are provided together.

It is possible that the slush skin comprises plastic material, and/or the slush skin is glued and/or mechanically fixed to the housing, with preferably one protective layer and/or a glue layer being interposed, and/or the slush skin or the décor layer can cover more than one layer stack to a provide a multisensor area.

In another embodiment the stack of layers and the base plate are prepared together, with preferably the base plate or wall and/or the protective layer and/or the electrode being arranged thereto being provided as combined component.

In another embodiment the electroactive polymer transducer device is used as an actuator device and/or as a sensor device, further comprising the w control unit connected to the electrically conductive layers. The electroactive polymer transducer device can be operated as an actuator, when applying a suitable voltage to decrease or increase the layer thickness of the active areas via the electrostrictive effect, where so-called electrostrictive forces squeeze the dielectric elastic polymer material of the active area. Typical voltages to be applied to the active area are between 100V and 2000V. With a sufficient number of plastic material layers within the layer stack, a change of thickness of about 10% can be achieve in order to actuate a component connected to the stack of layers. The device can also be used in a sensing mode, where a constant voltage might be applied by a power supply controlled by the control unit to the active areas of the electroactive polymer transducer device and sensing a change of an applied default voltage induced by pressing on top of the stack of layers, for example by a finger touching the top of the layer stack. The default voltage might by applied by a power supply via the control unit also analyzing the induced voltage change due to an applied pressure to the stack of layers. The sensed voltage change can be used as a trigger signal to initiate a certain response or any following action of another component. The control unit may trigger the following actions as a response on the sensed voltage change.

Embodiments can be further characterized in that the slush skin is provided with at least one actuation area, preferably in form of a button, in particular with a first portion projecting from the slush skin away from the stack and/or with a second portion projecting from the slush skin towards the stack.

The invention further is suitable for a vehicle external or internal trim component, like a door trim or a dashboard, and for a vehicle in general.

The following drawings show aspects of the invention for improving the understanding of the invention in connection with some exemplary illustrations, wherein
- Fig. 1:: shows a schematic side view of a layer stack of a first electroactive polymer transducer device suitable for the present invention;
- Fig. 2: shows a schematically top view onto stacked active areas of plastic material layers of the layer stack of Fig. 1;
- Fig. 3: shows a schematically top view onto one embodiment of the layer sequence of first electrode / plastic material layer / second electrode;
- Fig. 4: shows a schematically top view onto another embodiment of the layer sequence of first electrode / plastic material layer / second electrode;
- Fig. 5: shows an embodiment of a vehicle;
- Fig. 6: shows a method to produce the electroactive polymer transducer device suitable for the present invention;
- Fig. 7: shows a method to operate the electroactive polymer transducer device according to the present invention;
- Fig. 8:: shows an exploded view of a layer stack for a second electroactive polymer transducer device suitable for the present invention;
- Fig. 9: shows a method to produce the layer stack of Fig. 8;
- Figs. 10A and 10B: each shows a cross sections of two alternatives of the second electroactive polymer transducer device;
- Figs. 11A and 11B: each shows a cross sections of a third electroactive polymer transducer device suitable for the present invention, and
- Fig.s. 12A and 12B: show different multisensor areas comprising a layer stack according to Fig. 8 in each sensor area.

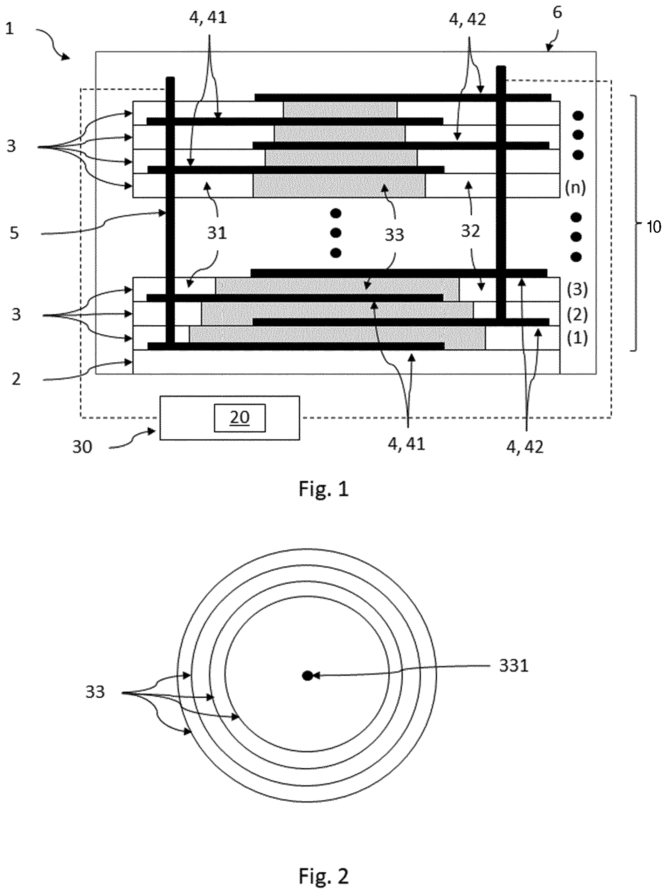

Fig.1 shows a schematic side view of a layer stack 10 of a first electroactive polymer transducer device 1 suitable for the present invention. Said stack 10 of multiple layers is deposited on a base plate 2. The multiple more than n layers are indicated on the right side with numbers (1), (2), (3) ... (n), .... The stack of layers may comprise 10 to 50 sequences of plastic material layer 3 and electrically conductive layer 4. The stack 10 comprises an alternating sequence of plastic material layers 3 and electrically conductive layers 4 on top of each other. The plastic material layers 3 each comprise an active area 33 made of an elastic polymer providing an electrostrictive effect (gray shaded areas) arranged laterally adjacent beside a first and a second fixation area 31, 32 made of solid plastic material in direct contact to the active area 33. The electrically conductive layers 4 are arranged in an alternating sequence of first and second electrodes 41, 42 to apply a voltage between first and second electrodes 41, 42 to the active areas 33 in order to induce or sense the electrostrictive effect of the elastic polymer, where the first electrode 41 at least partly covers a first fixation area 31 of the fixation area and the active area 33 of the adjacent plastic material layers 3 and the second electrode 42 at least partly covers a second fixation area 32 of the fixation area and the active area 33 of the adjacent plastic material layers.

Here a first electrode 41 is deposited on top of the base plate 2 followed by a plastic material layer 3 with a second electrode 42 deposited on top of the plastic material layer 3 followed by the next plastic material layer 3 on top of the second electrode 42 and so on until a second electrode layer 42 is deposited as the last layer of the stack of layers 10. The sequence of layers define a vertical direction of the stack 10 of layers perpendicular to the base plate 2, here the surface of the base plate 2, where the stack 10 is deposited on top. The lateral arrangement of areas 31, 32, 33 within one layer 3 denotes areas located beside each other in a direction parallel to the surface of the base plate 2, where the stack 10 is deposited on top.

The first electrodes 41 are connected in parallel to a first polarity of a power supply 20, while the second electrodes 42 are connected in parallel to a second polarity of the power supply 20 by separate conductive pins 5 extending through the stack of layers 10, the left one extending through the first contacting areas 411 and not the second contacting areas 421 and the right one extending through the second contacting areas 421 and not the first contacting areas 411. This simple contacting is enabled by first contacting areas 411 of the first electrodes 41 partly covering the first fixation areas 31 and the second electrodes 42 comprise second contacting areas 421 at least partly covering the second fixation areas 32, where when projected onto the base plate 2 the first contacting areas 411 do not or only partly cover the second contacting areas 421 and vice versa. Furthermore the size of the active areas 33 decreases from layer to layer starting with the biggest size for the plastic material layer 3 on top of the base plate 2.

The base plate 2 might be made of the solid plastic material also used to prepare the fixation areas 31, 32, preferably, 1 to 5 separate layers applied on top of each other establish the base plate. In other embodiments, the base plate might be made of other non-conducting materials providing a sufficient flat and smooth (non-rough) surface suitable to deposit the stack of layers on top. The layer stack 10 might be covered by a solid top cover 6 on a side opposite to the base plate 2. The solid top cover 6 might be made of hard plastic, which can be fitted to the top of the assembly providing a desired haptic feeling.

The stack of layers 10, preferably also the base plate 2, might be prepared by three-dimensional printing technology. The electroactive polymer transducer device 1 might be used as an actuator device and/or or as a sensor device further comprising a control unit 30 connected to the electrically conductive layers 4.

Fig. 2 shows a schematically top view onto the stacked active areas 33 of the plastic material layers 3. For a better overview, only the active areas 33 of the plastic material layers 3 are shown. Here the size of the active areas 33 decreases from layer to layer starting with the biggest size for the plastic material layer 3 on top of the base plate 2. The active areas 33 are arranged symmetrically to the active area 33 underneath, where a center 331 of the active areas 33 coincidence for all active areas 33. The active areas 33 have a circular shape and are arranged in a concentric way seen in a vertical direction to a surface of the active areas 33.

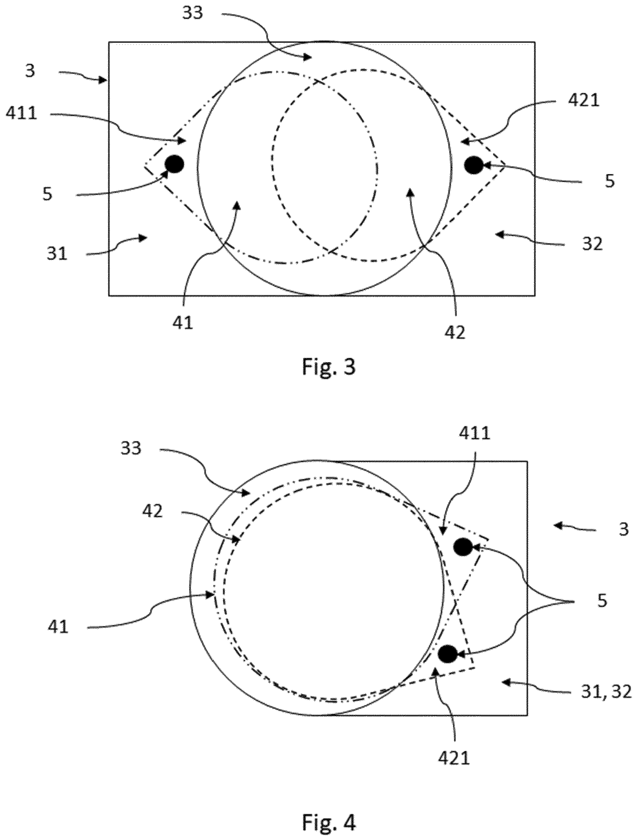

Fig. 3 shows a schematically top view onto one embodiment of the layer sequence of first electrode 41 / plastic material layer 3 / second electrode 42. In the plastic material layer 3 the first and second fixation areas 31, 32 laterally fully embrace the active area 33 in this embodiment. The shown layer structure corresponds to the stack of layers 10 shown in figure 1. Here the first and second electrodes 41, 42 have smooth circular shape in lateral direction without edges at least in the area covering the active areas of the plastic material layers 3 when seen in a vertical direction to a surface of the first and second electrodes 41, 42, where the shape of the electrodes 41, 42 is completed by tangential lines touching each of the electrodes 41, 42 in just one point. The areas of the electrodes 41, 42 outside the active area 33 (not covering the active area 33) are the first and second contacting areas 411, 421, where the vertical pin 5 is positioned.

Fig. 4 shows a schematically top view onto another embodiment of the layer sequence of first electrode 41 / plastic material layer 3 / second electrode 42. Here the plastic material layer 3 comprise an active area 33 arranged laterally adjacent to the fixation area 31, 32 only provided on one side (right side) of the active area 33. Also here the first and second electrodes 41, 42 have smooth circular shape in lateral direction without edges at least in the area covering the active areas 33 of the plastic material layers 3 when seen in a vertical direction to a surface of the first and second electrodes 41, 42, where the shape of the electrodes 41, 42 is completed by tangential lines touching each of the electrodes 41, 42 in just one point. The areas of the electrodes 41, 42 outside the active area 33 (not covering the active area 33) are the first and second contacting areas 411, 421, where the vertical pin 5 is positioned. The first and second contacting areas are slightly shifted against each other in order to essentially avoid coverage of one of the contacting surfaces 411 dedicated to one electrode 41 by the other contacting surface 421 dedicated to the other electrode 42. As can be seen from Fig. 4, the electroactive polymer transducer device 1 can be manufactured with smaller lateral sizes compared to the electroactive polymer transducer device 1 of Fig. 3.

However the mechanical stability of the active area and therefore of the whole electroactive polymer transducer device 1 of Fig. 3 is larger than for the electroactive polymer transducer device 1 of Fig. 4.

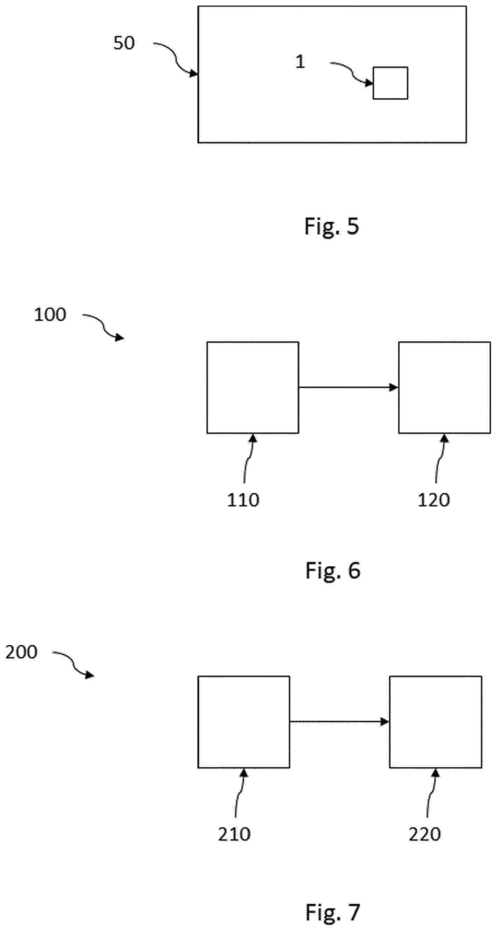

Fig. 5 shows an embodiment of a vehicle 50 comprising at least one electroactive polymer transducer device 1 used as an actuator device and/or or as a sensor device. The vehicle 50 might be a motorized or non-motorized vehicle. It might be a two-wheel, three-wheel, four-wheel vehicle or a more wheels comprising vehicle 50. The vehicle 50 might be used to transport people and/or objects. The vehicle 50 might be driven by a driver or an autonomous driven vehicle. The vehicle 50 might comprise a door trim or a dashboard with an electroactive polymer transducer device 1.

Fig. 6 shows a method to produce the electroactive polymer transducer device 1 suitable for the present invention, comprising the steps of providing 110 a base plate 2 for a stack 10 of multiple layer to be prepared on top of the base plate 2 and preparing 120 the stack 10 comprising an alternating sequence of plastic material layers 3 and electrically conductive layers 4 on top of each other by three-dimensional printing technology, where the plastic material layers 3 each comprise an active area 33 made of an elastic polymer providing an electrostrictive effect arranged laterally adjacent to at least one fixation area 31, 32 made of solid plastic material in direct contact to the active area 33, where the electrically conductive layers 4 are arranged in an alternating sequence of first and second electrodes 41, 42 to apply a voltage between first and second electrodes 41, 42 to the active areas 33 in order to induce or sense the electrostrictive effect of the elastic polymer, and where the first electrode 41 at least partly covers a first fixation area 31 of the fixation area and the active area 33 of the adjacent plastic material layers 3 and the second electrode 42 at least partly covers a second fixation area 32 of the fixation area and the active area 33 of the adjacent plastic material layers. Here also the base plate 10 is prepared by three-dimensional printing technology.

Fig. 7 shows a method to operate the electroactive polymer transducer device 1 according to the present invention as combined actuator and sensing device with good haptic feedback in a click operation as a switch, comprising the steps of applying 210 a counter-voltage to the electrically conductive layers 4 by a control unit 30 in order to hamper a thickness-reduction of the active area 33 of the plastic material layers 3 when beginning to apply an external mechanical force to the electroactive polymer transducer devices 1 until a common click-point is reached, and reversing 220 the applied voltage by the control unit 30 after the common click-point is passed to support the click operation.

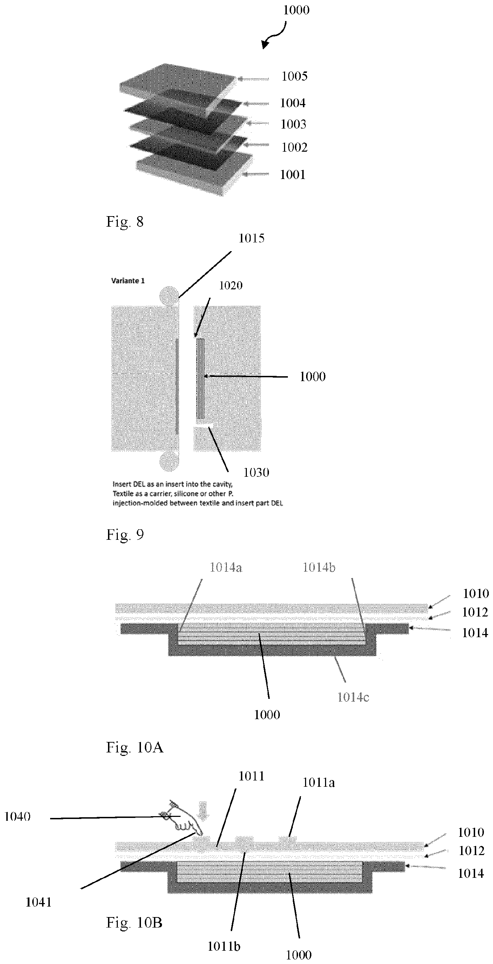

Fig. 8 shows an exploded view of a layer stack 1000 for a second electroactive polymer transducer device suitable for the present invention. The layer stack 1000 comprises, on top of each other, a protective layer 1001, an electrode layer 1002, a dielectric layer 1003, a further electrode layer 1004 and a further protective layer 1005. Using three-dimensional printing technology allows serial production.

Said layer stack 1000 can be inserted into a cavity of a housing 1014 by providing the same on a thin carrier such as a textile film 1015 for transfer into the cavity by passing a gap 1020 as shown in Fig. 9. With the carrier the layer stack 1000, preferably also being provided in form of a thin film, becomes more stable and more resistant, wherein the thickness of the film can be varied, depending on the desired sensitivity of the electroactive polymer transducer device.

Said cavity is defined by a base wall 1014c and at least one housing wall 1014a, 1014b extending therefrom, in Fig. 9 upwards. The housing 1014 can also be formed by injection molding as illustrated via an injection port 1030.

As a result of the insertion of the layer stack 1000 into the cavity, the lower protective layer 1001 rests on the base wall 1014c, whereas the upper protective layer 1005 flushes with the upper edge of the housing 1014, see Fig. 10A or Fig. 10B. Both alternatives of Figs. 10A and 10B further show a glue layer 1012 on top of the upper edge of the housing 1014 and the upper protective layer 1005 to attach a slush skin 1010 providing a HMI.

In the embodiment of Fig. 10B, the HMI comprises actuating areas in form of buttons 1011, which can be pushed by a finger 1041 of the hand 1040 of a user. Said buttons 1011 each can comprise an upper portion 1011a projecting upwardly and a lower portion 1011b extending downwardly in direction of the layer stack 1000.

Mounting a layer stack under a surface or under a liner in form of the slush skin, in addition to or as alternative to the top protective layer, allows to provide a solid button feeling. The attachment of the surface or under a liner, whether it is with glue or mechanical anchoring, further facilitates serial implementation.

Thus, the production of electroactive polymer transducer devices in larger quantities and high accuracy is possible, in particular due to the described manufacturing process of the layer stack. This even allows to produce wearable structures on a carrier as intermediate product, which can be inserted into a cavity provided e.g. in the exterior or interior of a vehicle, like a door trim or a dashboard.

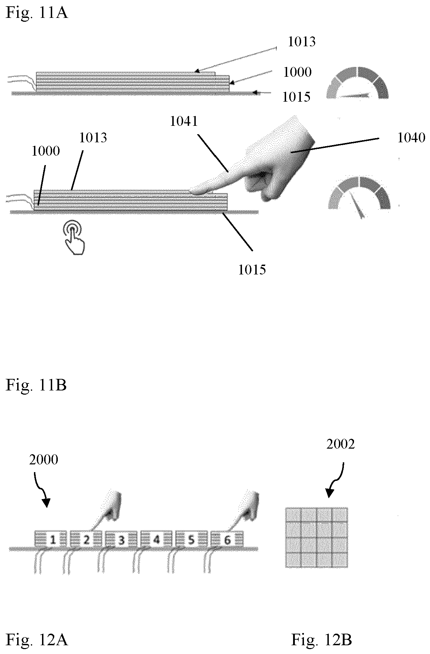

It is to be noted that the layer stack 1000, which is based on the principle of a plane-parallel capacitor, and can provide a dielectric elastomer sensor, can simply consist of a flexible and stretchable dielectric polymer layer 1003 sandwiched between two compliant electrode layers 1002, 1004, deposited on a textile film 1015 and covered by a decor layer 1013, as shown in Fig. 11A. This structure is beneficial for providing a flexible and sensitive dielectric elastomer tactile sensor, similar to human skin. Such a sensor can be used for measuring mechanical deformations, such as pressure, strain, shear and torsion and can produce vibration or stroke as confirmation of such a deformation, with an example of such a deformation being shown in Fig. 11B.

The sensor of Figs. 11A and 11B is in particular suited to be used in a method as described with respect to Fig. 7 in order to provide a surface feedback or haptic mechanism. The surface feedback mechanism can be the same haptic mechanism which is used for the confirmation of a HMI function with a localized feedback as provided by a conventional push button.

There is no need for positioning the sensor, in particular the layer stack 1000, on a surface or make it visible, and there is no need for an additional sensor to provide coordinates of a body part on a surface.

With the described sensor, it is possible to provide blind guidance to a body part, especially a finger 1041, to reach a correct location on a surface without having an additional layer providing coordinates or the like. Said correct location is defined by an active area and/or virtual button area described above.

The sensor can detect different signals as pressure, strain, shear and torsion and at the same time can create a movement.

The feedback mechanism to guide said body part only activates after proximity thereof is determined, which results into an optimized system performance. The same function and control mechanism is flexible and applicable to any size of surface without a change of principle method of operation. This provides an optimized solution for different form factors without changing control mechanism.

Figs. 12A and 12B each show the usage of a layer stack 1000 in a multisensor area. The area of Fig. 12A comprises 6 sensors each having a layer stack 1000 as described with respect to Fig. 10A, and the area of Fig. 12B comprises 16 sensors, provided by one layer stack 1000 of Fig. 10B. Such sensor areas can be used, for example, in an internal or external vehicle component as described with respect to Fig. 5 above.

### Reference Numerals

- 1: electroactive polymer transducer device
- 2: base plate
- 3: plastic material layers
- 4: electrically conductive layers
- 5: conductive pin or via
- 6: solid top cover
- 10: stack of layers
- 20: power supply
- 30: control unit
- 31: fixation area, first fixation areas
- 32: fixation area, second fixation areas
- 33: active area
- 41: first electrodes
- 42: second electrodes
- 50: vehicle
- 100: method to produce an electroactive polymer transducer device
- 110: providing a base plate
- 120: preparing the stack of multiple layers on top of the base plate
- 200: method to operate an electroactive polymer transducer device
- 210: applying a counter-voltage to the electrically conductive layers
- 220: reversing the applied voltage
- 331: center of the active area
- 411: first contacting areas
- 421: second contacting areas
- 1000: stack of layers
- 1001: protective layer
- 1002: electrode layer
- 1003: dielectric layer
- 1004: electrode layer
- 1005: protective layer
- 1010: slush skin
- 1011: button
- 1011a: upper portion
- 1011b: lower portion
- 1012: glue layer
- 1013: décor layer
- 1014: plastic housing
- 1014a: housing side wall
- 1014b: housing side wall
- 1014c: housing base wall
- 1015: textile film
- 1020: gap
- 1030: injection point
- 1040: hand
- 1041: finger
- 2000: vehicle component with multisensor area
- 2002: vehicle component with multisensor area

## Claims

1. A method (200) to operate an electroactive polymer transducer device (1) as combined actuator and sensing device with good haptic feedback in a click operation as a switch, **characterized in that** it comprises the steps of
- applying (210) a counter-voltage to electrically conductive layers (4, 1002, 1004) having at least one plastic material layer (3, 1003) comprising dielectric electroactive polymer material arranged therebetween, by a control unit (30), in order to hamper a thickness-reduction of an active area (33) of the plastic material layer(s) (3, 1003) when beginning to apply an external mechanical force to the electroactive polymer transducer device (1), preferably in at least one actuation area, until a common click point is reached, and
- reversing (220) the applied voltage by the control unit (30) after the common click-point is passed to support the click operation.

2. The method according to claim 1,
wherein the
electrically conductive layers (4, 1002, 1004) and the plastic material layer(s) (3, 1003) are provided by the electroactive polymer transducer device (1) comprising at least one stack (10, 1000) of multiple layers deposited on a base film, plate or wall (2, 1014c, 1015) and/or within a housing (1014) with at least one housing wall (1014a, 1014b), preferably extending from a base wall (1014c), where the stack (10, 1000) comprises an alternating sequence of plastic electroactive material layers (3, 1003) and electrically conductive layers (4, 1002, 1004) on top of each other, with at least one plastic material layer (3, 1003), being sandwiched between two electrically conductive layers (4, 1002, 1004),
wherein each plastic material layer (3, 1003) comprises at least one active area (33) made of an elastic polymer providing an electrostrictive effect, with the active area (33) being arranged laterally adjacent to at least one fixation area (31, 32) or at least one housing wall (1014a, 1014b) made of solid plastic material in direct contact to the active area (33), and/or the active area (33) extending across the complete plastic material layer (3, 1003),
wherein the electrically conductive layers (4, 1002, 1004) are arranged in an alternating sequence of first and second electrodes (41, 42, 1002, 1004) to apply a voltage between first and second electrodes (41, 42, 1002, 1004) to the respective active area(s) (33) in order to induce or sense the electrostrictive effect of the elastic polymer of the plastic material layer(s) (3, 1003) arranged therebetween, and
wherein the stack of layers (10, 1000) is prepared by three-dimensional printing technology.

3. The method according to claim 2,
wherein
• in case the multiple layers are deposited on a base plate (2), the first electrode (41) at least partly covers a first fixation area (31) of the fixation area and the active area (33) of the adjacent plastic material layers (3) and the second electrode (42) at least partly covers a second fixation area (32) of the fixation area and the active area (33) of the adjacent plastic material layers, or
• in case the multiple layers are deposited within a cavity defined by the at least one housing wall (1014a, 1014b), preferably by the at least one housing wall (1014a, 1014b) and the base wall (1014c) of the housing (1014), all layers (1001 - 1005) are in contact with the at least one wall (1014a, 1014b).

4. The method according to claim 2 or 3,
wherein there
is a plurality of first electrodes (41) and a plurality of second electrodes (42), with preferably the stack of layers (10) comprising 10 to 50 sequences of plastic material layer (3) and electrically conductive layer (4).

5. The method according to claim 4,
wherein the
first electrodes (41) are connected in parallel to be connected to a first polarity of a power supply (20), while the second electrodes (42) are connected in parallel to be connected to a second polarity of the power supply (20).

6. The method according to claim 5,
wherein the
first electrodes (41) comprise first contacting areas (411) at least partly covering the first fixation areas (31) and the second electrodes (42) comprise second contacting areas (421) at least partly covering the second fixation areas (32), and wherein, when projected onto the base plate (2), the first contacting areas (411) at least do not fully cover the second contacting areas (421) and vice versa.

7. The method according to claim 6,
wherein the
parallel connection of the first electrodes and also of the second electrodes (41, 42) is established by at least two separate conductive pins or vias (5) extending through the stack of layers (10), of which at least one extends through the first contacting areas (411) and not the second contacting areas (421) and of which at least one other extends through the second contacting areas (421) and not the first contacting areas (411).

8. The method according to one of claims 2-7,
wherein the
fixation area (31, 32) comprises separate first and second fixation areas (31, 32), and wherein
the active area (33) of each plastic material layer (3) is arranged laterally between first and second fixation areas (31, 32) in direct contact to the active area (33).

9. The method according to one of claims 2-8,
wherein the
electrically conductive layers (4, 1002, 1004) have a smooth shape in lateral direction without edges at least in an area covering the active areas of the plastic material layers (3, 1003), preferably the electrically conductive layers (4) are circular shaped layers seen in a direction perpendicular to a surface of the conductive layers (4).

10. The method according to any of claims 4 to 9,
wherein the
size of the active areas (33) decreases from layer to layer starting with the biggest size for the plastic material layer (3) on top of the base plate (2),
with preferably the active areas (33) being arranged symmetrically to the active area (33) underneath, and centers (331) of the active areas (33) coinciding for all active areas (33), and/or
with preferably the active areas (33) having a circular shape and being arranged in a concentric way seen in a direction perpendicular to a surface of the active areas (33).

11. The method according to one of claims 2-10,
wherein the
base plate (2) is made of the solid plastic material also used to prepare the fixation areas (31, 32), preferably the base plate is established by 1 to 5 separate layers applied on top of each other, or
the base film (1015) comprises a stretchable and/or deformable layer, in particular in form of a textile film.

12. The method according to one of claims 2-11,
wherein in
the plastic material layer (3) the first and second fixation areas (31, 32) laterally fully embrace the active area (33), and/or
the complete plastic material layer (1003) provides an active area.

13. The method according to one of claims 2-12,
wherein the
layer stack (1000) comprises a protective layer (1001, 1005) on at least one of its two opposite sides, and/or
the layer stack (10, 1000) is covered by a solid top cover (6) or a slush skin (1010) and/or a décor layer (1013) on a side opposite to the base film, plate or wall (2, 1014c, 1015).

14. The method according to claim 13,
wherein the
slush skin (1010) comprises plastic material, and/or
the slush skin (1010) is glued and/or mechanically fixed to the housing (1014), with preferably one protective layer (1005) and/or a glue layer (1012) being interposed, and/or
the slush skin (1010) or the décor layer (1013) can cover more than one layer stack (1000) to provide a multisensor area.

15. The method according to one of claims 2-14,
wherein the
stack of layers (10) and the base plate or wall (2, 1014c) are prepared together, with preferably the base plate or wall (2, 1014c) and/or the protective layer (1001) and/or the electrode (1002) being arranged next thereto being provided as a combined component.

16. The method according to one of the preceding claims,
wherein the
electroactive polymer transducer device (1) is used as an actuator device and/or as a sensor device, the control unit (30) being connected to the electrically conductive layers (4, 1002, 1004).

17. The method according to claim 13 or 14,
wherein the
slush skin (1010) is provided with at least one actuation area, preferably in form of a button (1011), in particular with a first portion (1011a) projecting from the slush skin (1010) away from the stack (1000) and/or with a second portion (1011b) projecting from the slush skin (1010) towards the stack (1000),
wherein the at least one actuation area is preferably aligned with the at least one active area.

## Patentansprüche

1. Verfahren (200) zum Bedienen einer elektroaktiven Polymertransducervorrichtung (1) als kombinierte Betätigungs- und Abtastvorrichtung mit guter haptischer Rückmeldung in einem Klickvorgang als Schalter,
**dadurch gekennzeichnet, dass** es folgende Schritte umfasst:
- Anlegen (210) einer Gegenspannung an elektrisch leitfähige Schichten (4, 1002, 1004) mit mindestens einer Kunststoffmaterialschicht (3, 1003), umfassend dazwischen angeordnetes dielektrisches elektroaktives Polymermaterial, durch eine Steuereinheit (30), um eine Verringerung der Dicke eines aktiven Bereiches (33) der Kunststoffmaterialschicht(en) (3, 1003) zu hemmen, wenn damit begonnen wird, eine äußere mechanische Kraft auf die elektroaktive Polymertransducervorrichtung (1) auszuüben, vorzugsweise in mindestens einem Betätigungsbereich, bis ein gemeinsamer Klickpunkt erreicht ist, und
- Umkehren (220) der angelegten Spannung durch die Steuereinheit (30) nach dem Überschreiten des gemeinsamen Klickpunktes, um den Klickvorgang zu unterstützen.

2. Verfahren nach Anspruch 1,
wobei die elektrisch leitfähigen Schichten (4, 1002, 1004) und die Kunststoffmaterialschicht(en) (3, 1003) durch die elektroaktive Polymertransducervorrichtung (1) bereitgestellt werden, umfassend mindestens einen Stapel (10, 1000) von mehreren Schichten, aufgebracht auf einem/einer Basisfilm, - platte oder -wand (2, 1014c, 1015) und/oder innerhalb eines Gehäuses (1014) mit mindestens einer Gehäusewand (1014a, 1014b), vorzugsweise sich von einer Basiswand (1014c) aus erstreckend, wo der Stapel (10, 1000) eine alternierende Abfolge von übereinander angeordneten elektroaktiven Kunststoffmaterialschichten (3, 1003) und elektrisch leitfähigen Schichten (4, 1002, 1004) umfasst, mit mindestens einer Kunststoffmaterialschicht (3, 1003), die zwischen zwei elektrisch leitfähigen Schichten (4, 1002, 1004) eingelegt ist,
wobei jede Kunststoffmaterialschicht (3, 1003) mindestens einen aktiven Bereich (33), hergestellt aus einem elastischen Polymer, bereitstellend einen elektrostriktiven Effekt, umfasst, wobei der aktive Bereich (33) seitlich benachbart zu mindestens einem Befestigungsbereich (31, 32) oder mindestens einer Gehäusewand (1014a, 1014b), hergestellt aus festem Kunststoffmaterial in direktem Kontakt mit dem aktiven Bereich (33), angeordnet ist, und/oder der aktive Bereich (33) sich quer über die gesamte Kunststoffmaterialschicht (3, 1003) erstreckt,
wobei die elektrisch leitfähigen Schichten (4, 1002, 1004) in einer alternierenden Abfolge von ersten und zweiten Elektroden (41, 42, 1002, 1004) angeordnet sind, um eine Spannung zwischen ersten und zweiten Elektroden (41, 42, 1002, 1004) an den/die jeweiligen aktiven Bereich(e) (33) anzulegen, um den elektrostriktiven Effekt des elastischen Polymers der Kunststoffmaterialschicht(en) (3, 1003), angeordnet dazwischen, zu induzieren oder abzutasten, und
wobei der Stapel von Schichten (10, 1000) mittels dreidimensionaler Drucktechnologie hergestellt wird.

3. Verfahren nach Anspruch 2,
wobei,
• falls die mehreren Schichten auf einer Basisplatte (2) aufgebracht werden, die erste Elektrode (41) einen ersten Befestigungsbereich (31) des Befestigungsbereiches und den aktiven Bereich (33) der benachbarten Kunststoffmaterialschichten (3) zumindest teilweise bedeckt und die zweite Elektrode (42) einen zweiten Befestigungsbereich (32) des Befestigungsbereiches und den aktiven Bereich (33) der benachbarten Kunststoffmaterialschichten zumindest teilweise bedeckt, oder
• falls die mehreren Schichten innerhalb eines Hohlraumes, definiert durch die mindestens eine Gehäusewand (1014a, 1014b), vorzugsweise durch die mindestens eine Gehäusewand (1014a, 1014b) und die Basiswand (1014c) des Gehäuses (1014), aufgebracht werden, alle Schichten (1001 - 1005) in Kontakt mit der mindestens einen Wand (1014a, 1014b) stehen.

4. Verfahren nach Anspruch 2 oder 3,
wobei eine Mehrzahl von ersten Elektroden (41) und eine Mehrzahl von zweiten Elektroden (42) vorhanden sind, wobei vorzugsweise der Stapel von Schichten (10) 10 bis 50 Abfolgen aus Kunststoffmaterialschicht (3) und elektrisch leitfähiger Schicht (4) umfasst.

5. Verfahren nach Anspruch 4,
wobei die ersten Elektroden (41) parallelgeschaltet werden, um an eine erste Polarität einer Stromversorgung (20) angeschlossen zu werden, wohingegen die zweiten Elektroden (42) parallelgeschaltet werden, um an eine zweite Polarität der Stromversorgung (20) angeschlossen zu werden.

6. Verfahren nach Anspruch 5,
wobei die ersten Elektroden (41) erste Kontaktierbereiche (411) umfassen, die die ersten Befestigungsbereiche (31) zumindest teilweise bedecken, und die zweiten Elektroden (42) zweite Kontaktierbereiche (421) umfassen, die die zweiten Befestigungsbereiche (32) zumindest teilweise bedecken, und wobei die ersten Kontaktierbereiche (411), wenn sie auf die Basisplatte (2) ragen, die zweiten Kontaktierbereiche (421) zumindest nicht vollständig bedecken und umgekehrt.

7. Verfahren nach Anspruch 6,
wobei die Parallelschaltung der ersten Elektroden und auch der zweiten Elektroden (41, 42) durch mindestens zwei separate leitfähige Stifte oder Durchkontaktierungen (5), die sich durch den Stapel von Schichten (10) erstrecken, gebildet wird, von denen mindestens einer/eine sich durch die ersten Kontaktierbereiche (411) und nicht die zweiten Kontaktierbereiche (421) erstreckt und von denen mindestens ein/eine andere/r sich durch die zweiten Kontaktierbereiche (421) und nicht die ersten Kontaktierbereiche (411) erstreckt.

8. Verfahren nach einem der Ansprüche 2-7,
wobei der Befestigungsbereich (31, 32) separate erste und zweite Befestigungsbereiche (31, 32) umfasst und wobei der aktive Bereich (33) jeder Kunststoffmaterialschicht (3) seitlich zwischen ersten und zweiten Befestigungsbereichen (31, 32) in direktem Kontakt mit dem aktiven Bereich (33) angeordnet ist.

9. Verfahren nach einem der Ansprüche 2-8,
wobei die elektrisch leitfähigen Schichten (4, 1002, 1004) eine glatte Form in seitlicher Richtung ohne Kanten zumindest in einem Bereich, der die aktiven Bereiche der Kunststoffmaterialschichten (3, 1003) bedeckt, aufweisen, vorzugsweise die elektrisch leitfähigen Schichten (4), gesehen in einer Richtung, die senkrecht zu einer Oberfläche der leitfähigen Schichten (4) verläuft, kreisförmige Schichten sind.

10. Verfahren nach einem der Ansprüche 4 bis 9,
wobei die Größe der aktiven Bereiche (33) von Schicht zu Schicht, beginnend mit der größten Größe für die Kunststoffmaterialschicht (3) zuoberst auf der Basisplatte (2), abnimmt,
vorzugsweise die aktiven Bereiche (33) symmetrisch zu dem darunterliegenden aktiven Bereich (33) angeordnet sind und Mittelpunkte (331) der aktiven Bereiche (33) sich für alle aktiven Bereiche (33) decken und/oder
vorzugsweise die aktiven Bereiche (33) kreisförmig sind und gesehen in einer Richtung, die senkrecht zu einer Oberfläche der aktiven Bereiche (33) verläuft, konzentrisch angeordnet sind.

11. Verfahren nach einem der Ansprüche 2-10,
wobei die Basisplatte (2) aus dem festen Kunststoffmaterial hergestellt wird, das auch dazu verwendet wird, die Befestigungsbereiche (31, 32) herzustellen, vorzugsweise die Basisplatte durch 1 bis 5 separate Schichten, die übereinander aufgebracht werden, gebildet wird, oder
der Basisfilm (1015) eine dehnbare und/oder verformbare Schicht, insbesondere in Form eines Textilfilmes, umfasst.

12. Verfahren nach einem der Ansprüche 2-11,
wobei in der Kunststoffmaterialschicht (3) die ersten und zweiten Befestigungsbereiche (31, 32) den aktiven Bereich (33) seitlich vollständig umschließen und/oder
die gesamte Kunststoffmaterialschicht (1003) einen aktiven Bereich bereitstellt.

13. Verfahren nach einem der Ansprüche 2-12,
wobei der Schichtenstapel (1000) eine Schutzschicht (1001, 1005) auf mindestens einer seiner zwei gegenüberliegenden Seiten umfasst und/oder
der Schichtenstapel (10, 1000) durch eine feste obere Abdeckung (6) oder eine Slush-Haut (1010) und/oder eine Dekorschicht (1013) auf einer dem/der Basisfilm, -platte oder -wand (2, 1014c, 1015) gegenüberliegenden Seite bedeckt wird.

14. Verfahren nach Anspruch 13,
wobei die Slush-Haut (1010) Kunststoffmaterial umfasst und/oder die Slush-Haut (1010) an das/dem Gehäuse (1014) geklebt und/oder mechanisch befestigt wird, wobei dazwischen vorzugsweise eine Schutzschicht (1005) und/oder eine Klebstoffschicht (1012) eingefügt werden/wird, und/oder
die Slush-Haut (1010) oder die Dekorschicht (1013) mehr als einen Schichtenstapel (1000) bedecken kann, um einen Multisensorbereich bereitzustellen.

15. Verfahren nach einem der Ansprüche 2-14,
wobei der Stapel von Schichten (10) und die Basisplatte oder -wand (2, 1014c) zusammen hergestellt werden, wobei vorzugsweise die Basisplatte oder -wand (2, 1014c) und/oder die Schutzschicht (1001) und/oder die Elektrode (1002), angeordnet daneben, als kombiniertes Bauelement bereitgestellt werden.

16. Verfahren nach einem der vorangehenden Ansprüche,
wobei die elektroaktive Polymertransducervorrichtung (1) als Betätigungsvorrichtung und/oder als Sensorvorrichtung verwendet wird, wobei die Steuereinheit (30) an die elektrisch leitfähigen Schichten (4, 1002, 1004) angeschlossen ist.

17. Verfahren nach Anspruch 13 oder 14,
wobei die Slush-Haut (1010) mit mindestens einem Betätigungsbereich versehen ist, vorzugsweise in Form eines Knopfes (1011), insbesondere mit einem ersten Abschnitt (1011a), der von der Slush-Haut (1010) aus von dem Stapel (1000) weg ragt, und/oder mit einem zweiten Abschnitt (1011b), der von der Slush-Haut (1010) aus in Richtung des Stapels (1000) hin ragt,
wobei der mindestens eine Betätigungsbereich vorzugsweise auf den mindestens einen aktiven Bereich ausgerichtet ist.

## Revendications

1. Procédé (200) destiné à faire fonctionner un dispositif transducteur à polymère électroactif (1) en tant qu'actionneur et dispositif de détection combiné avec une bonne rétroaction haptique dans une opération de cliquage en tant que commutateur, **caractérisé en ce qu'**il comprend les étapes consistant à :
- appliquer (210) une contre-tension à des couches électroconductrices (4, 1002, 1004) présentant au moins une couche de matière plastique (3, 1003) comprenant une matière polymère électroactive diélectrique agencée entre celles-ci, au moyen d'une unité de commande (30), afin d'entraver une réduction d'épaisseur d'une zone active (33) de la / des couche(s) de matière plastique (3, 1003) quand une force mécanique externe commence à être appliquée au dispositif transducteur à polymère électroactif (1), de préférence dans au moins une zone d'actionnement, jusqu'à ce qu'un point de cliquage commun soit atteint, et
- inverser (220) la tension appliquée au moyen de l'unité de commande (30) une fois le point de cliquage commun dépassé pour prendre en charge l'opération de cliquage.

2. Procédé selon la revendication 1,
dans lequel les couches électroconductrices (4, 1002, 1004) et la/les couche(s) de matière plastique (3, 1003) sont fournies par le fait que le dispositif transducteur à polymère électroactif (1) comprend au moins un empilement (10, 1000) de multiples couches déposées sur un film, une plaque ou une paroi de base (2, 1014c, 1015) et/ou à l'intérieur d'un boîtier (1014) avec au moins une paroi de boîtier (1014a, 1014b), s'étendant de préférence depuis une paroi de base (1014c), l'empilement (10, 1000) comprenant une séquence alternée de couches de matière électroactive plastique (3, 1003) et de couches électroconductrices (4, 1002, 1004) placées les unes sur les autres, au moins une couche de matière plastique (3, 1003) étant prise en sandwich entre deux couches électroconductrices (4, 1002, 1004),
dans lequel chaque couche de matière plastique (3, 1003) comprend au moins une zone active (33) constituée d'un polymère élastique fournissant un effet électrostrictif, la zone active (33) étant agencée de manière latéralement adjacente à au moins une zone de fixation (31, 32) ou au moins une paroi de boîtier (1014a, 1014b) constituée de matière plastique solide en contact direct avec la zone active (33), et/ou la zone active (33) s'étendant sur toute la couche de matière plastique (3, 1003),
dans lequel les couches électroconductrices (4, 1002, 1004) sont agencées dans une séquence alternée de premières et secondes électrodes (41, 42, 1002, 1004) pour appliquer une tension entre des premières et secondes électrodes (41, 42, 1002, 1004) à la / aux zone(s) active(s) (33) respective(s) afin d'induire ou de détecter l'effet électrostrictif du polymère élastique de la /des couche(s) de matière plastique (3, 1003) agencées entre celles-ci, et
dans lequel l'empilement de couches (10, 1000) est préparé au moyen d'une technologie d'impression en trois dimensions.

3. Procédé selon la revendication 2,
dans lequel
• dans le cas où les multiples couches sont déposées sur une plaque de base (2), la première électrode (41) recouvre au moins en partie une première zone de fixation (31) de la zone de fixation et la zone active (33) des couches de matière plastique (3) adjacentes et la seconde électrode (42) recouvre au moins en partie une seconde zone de fixation (32) de la zone de fixation et la zone active (33) des couches de matière plastique adjacentes, ou
• dans le cas où les multiples couches sont déposées dans une cavité définie par l'au moins une paroi de boîtier (1014a, 1014b), de préférence par l'au moins une paroi de boîtier (1014a, 1014b) et la paroi de base (1014c) du boîtier (1014), toutes les couches (1001 - 1005) sont en contact avec l'au moins une paroi (1014a, 1014b).

4. Procédé selon la revendication 2 ou 3,
dans lequel il y a une pluralité de premières électrodes (41) et une pluralité de secondes électrodes (42),
l'empilement de couches (10) comprenant de préférence 10 à 50 séquences de couche de matière plastique (3) et couche électroconductrice (4).

5. Procédé selon la revendication 4,
dans lequel les premières électrodes (41) sont connectées en parallèle de façon à être connectées à une première polarité d'une alimentation électrique (20), tandis que les secondes électrodes (42) sont connectées en parallèle de façon à être connectées à une seconde polarité de l'alimentation électrique (20).

6. Procédé selon la revendication 5,
dans lequel les premières électrodes (41) comprennent des premières zones de contact (411) recouvrant au moins en partie les premières zones de fixation (31) et les secondes électrodes (42) comprennent des secondes zones de contact (421) recouvrant au moins en partie les secondes zones de fixation (32), et dans lequel, en projection sur la plaque de base (2), les premières zones de contact (411) ne recouvrent au moins pas complètement les secondes zones de contact (421) et vice versa.

7. Procédé selon la revendication 6,
dans lequel la connexion en parallèle des premières électrodes et également des secondes électrodes (41, 42) est établie par au moins deux broches ou trous d'interconnexion (5) conducteurs séparés s'étendant à travers l'empilement de couches (10), dont au moins un(e) s'étend à travers les premières zones de contact (411) et pas à travers les secondes zones de contact (421) et dont au moins un(e) autre s'étend à travers les secondes zones de contact (421) et pas à travers les premières zones de contact (411).

8. Procédé selon l'une quelconque des revendications 2 à 7,
dans lequel la zone de fixation (31, 32) comprend des premières et secondes zones de fixations (31, 32) séparées, et dans lequel la zone active (33) de chaque couche de matière plastique (3) est agencée latéralement entre des premières et secondes zones de fixation (31, 32) en contact direct avec la zone active (33).

9. Procédé selon l'une quelconque des revendications 2 à 8,
dans lequel les couches électroconductrices (4, 1002, 1004) présentent une forme lisse dans la direction latérale sans arêtes au moins dans une zone recouvrant les zones actives des couches de matière plastique (3, 1003), les couches électroconductrices (4) sont de préférence des couches de forme circulaire lorsqu'elles sont vues dans une direction perpendiculaire à une surface des couches conductrices (4).

10. Procédé selon l'une quelconque des revendications 4 à 9,
dans lequel la taille des zones actives (33) diminue d'une couche à l'autre en commençant par la taille la plus grande pour la couche de matière plastique (3) placée sur le dessus de la plaque de base (2),
les zones actives (33) étant de préférence agencées de manière symétrique par rapport à la zone active (33) en dessous, et des centres (331) des zones actives (33) coïncidant pour toutes les zones actives (33), et/ou
les zones actives (33) présentant de préférence une forme circulaire et étant agencées de manière concentrique lorsqu'elles sont vues dans une direction perpendiculaire à une surface des zones actives (33).

11. Procédé selon l'une quelconque des revendications 2 à 10,
dans lequel la plaque de base (2) est fabriquée de la matière plastique solide également utilisée pour préparer les zones de fixation (31, 32), la plaque de base est de préférence établie par 1 à 5 couches séparées appliquées les unes sur les autres, ou
le film de base (1015) comprend une couche extensible et/ou déformable, en particulier sous la forme d'un film textile.

12. Procédé selon l'une quelconque des revendications 2 à 11,
dans lequel, dans la couche de matière plastique (3), les premières et secondes zones de fixation (31, 32) entourent latéralement toute la zone active (33), et/ou
la totalité de la couche de matière plastique (1003) fournit une zone active.

13. Procédé selon l'une quelconque des revendications 2 à 12,
dans lequel l'empilement de couches (1000) comprend une couche protectrice (1001, 1005) sur au moins un de ses deux côtés opposés, et/ou
l'empilement de couches (10, 1000) est recouvert d'un couvercle supérieur solide (6) ou d'une peau moulée par embouage (1010) et/ou d'une couche décorative (1013) sur un côté opposé au film, à la plaque ou à la paroi de base (2, 1014c, 1015).

14. Procédé selon la revendication 13,
dans lequel la peau moulée par embouage (1010) comprend de la matière plastique, et/ou
la peau moulée par embouage (1010) est collée et/ou fixée mécaniquement au boîtier (1014), une couche protectrice (1005) et/ou une couche adhésive (1012) étant de préférence intercalées, et/ou
la peau moulée par embouage (1010) ou la couche décorative (1013) peuvent recouvrir plus d'un empilement de couches (1000) afin de fournir une zone multicapteur.

15. Procédé selon l'une quelconque des revendications 2 à 14,
dans lequel l'empilement de couches (10) et la plaque ou paroi de base (2, 1014c) sont préparés ensemble, la plaque ou paroi de base (2, 1014c) et/ou la couche protectrice (1001) et/ou l'électrode (1002) étant de préférence agencées à côté de celui-ci, fournies sous la forme d'un composant combiné.

16. Procédé selon l'une quelconque des revendications précédentes,
dans lequel le dispositif transducteur polymère électroactif (1) est utilisé comme dispositif actionneur et/ou dispositif détecteur, l'unité de commande (30) étant connectée aux couches électroconductrices (4, 1002, 1004).

17. Procédé selon la revendication 13 ou 14,
dans lequel la peau moulée par embouage (1010) est pourvue d'au moins une zone d'actionnement, de préférence sous la forme d'un bouton (1011), en particulier avec une première partie (1011a) faisant saillie depuis la peau moulée par embouage (1010) dans la direction s'éloignant de l'empilement (1000) et/ou avec une seconde partie (1011b) faisant saillie depuis la peau moulée par embouage (1010) vers l'empilement (1000),
dans lequel l'au moins une zone d'actionnement est de préférence alignée avec l'au moins une zone active.
